(19)

Europäisches
Patentamt
European
Patent Office
Office européen
des brevets

(11) **EP 2 131 440 A1**

(12) **EUROPEAN PATENT APPLICATION**
published in accordance with Art. 153(4) EPC

(43) Date of publication:
**09.12.2009 Bulletin 2009/50**

(21) Application number: **08720347.7**

(22) Date of filing: **06.03.2008**

(51) Int Cl.:
*H01M 10/44* (2006.01)    *H01M 4/02* (2006.01)
*H01M 10/48* (2006.01)    *H02J 7/10* (2006.01)

(86) International application number:
**PCT/JP2008/000461**

(87) International publication number:
**WO 2008/108102 (12.09.2008 Gazette 2008/37)**

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **07.03.2007   JP 2007057073
13.02.2008   JP 2008032054**

(71) Applicant: **Panasonic Corporation
Kadoma-shi
Osaka 571-8501 (JP)**

(72) Inventors:
• **Jun ASAKURA
c/o Panasonic Corporation
Chuo-ku Osaka-shi
Osaka 540-6207 (JP)**

• **Takuma IIDA
c/o Panasonic Corporation
Shiromi, Chuo-ku Osaka-shi
Osaka 540-6207 (JP)**
• **Hajime NISHINO
c/o Panasonic Corporation
Shiromi, Chuo-ku Osaka-shi
Osaka 540-6207 (JP)**

(74) Representative: **Schwabe - Sandmair - Marx
Patentanwälte
Stuntzstrasse 16
81677 München (DE)**

(54) **QUICK CHARGING METHOD OF LITHIUM BASED SECONDARY BATTERY AND ELECTRONIC APPARATUS EMPLOYING IT**

(57)    A charging current is maintained at a predetermined constant quick charging current (S1) and a full charge determination is made at a point in time (S7) when the terminal voltage (V1) (S6) reaches the charge end voltage Vf'. The charge end voltage Vf' is taken as a voltage (S5) obtained by adding a voltage drop amount VD (S4) that is obtained by multiplying an internal resistance value (S3) estimated from the temperature T (S2) of a secondary battery by a quick charging current value to a predetermined initial charge end voltage Vf. Therefore, a constant high current can be supplied from the beginning to the end and quick charging can be performed up to a full charge, while preventing overcharge, in place of the conventional CC-CV charging.

FIG. 3

START

CHARGING CURRENT IS SUPPLIED — S1

TEMPERATURE T IS RECEIVED — S2

INTERNAL RESISTANCE VALUE R IS READ FROM TABLE — S3

VOLTAGE DROP VD IS CALCULATED — S4

CHARGE END VOLTAGE IS UPDATED AS Vf' — S5

TERMINAL VOLTAGE V1 IS DETECTED — S6

V1 ≧ Vf' — S7
NO
YES

CHARGING CURRENT SUPPLY IS ENDED — S8

END

EP 2 131 440 A1

## Description

Technical Field

The present invention relates to a method for quick charging of a lithium-based secondary battery and an electronic device using same.

Background Art

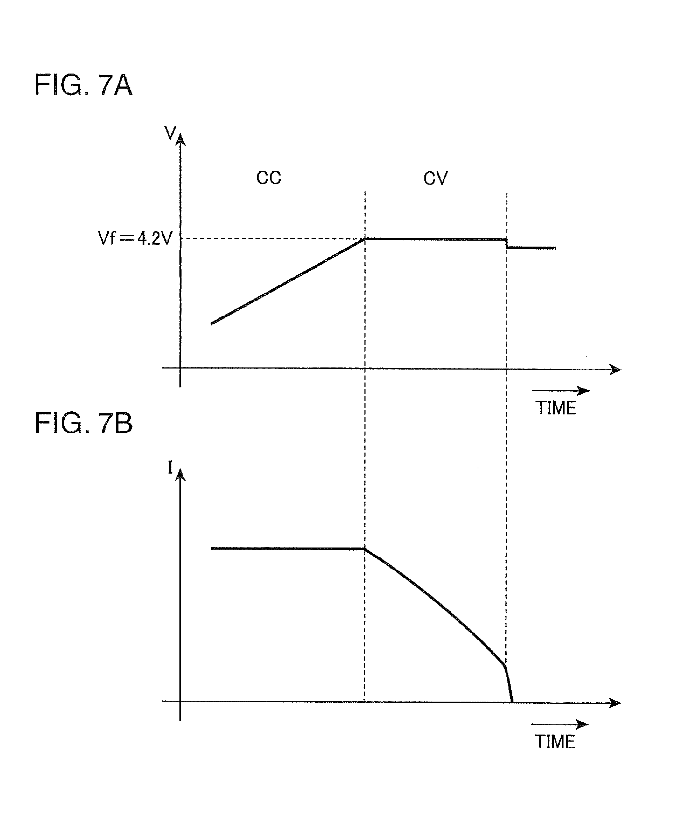

A CCCV (Constant Current Constant Voltage) charging method, for example, such as illustrated by FIG. 7, is known as a representative conventional method for charging a lithium-based secondary battery. With a standard CCCV charging method, first, the CC (constant current) charging is performed at a current of about 0.7 to 1C, where a current value at which a fully charged battery can be discharged to a SOC (State Of Charge) of 0% in 1 hour is taken as 1C. Then, after a terminal voltage of the battery becomes a predetermined charge end voltage, for example 4.2 V, the charging mode is switched to CV (constant voltage) charging that the charging current is reduced so as to maintain the charge end voltage. FIG. 7A is a graph illustrating the variation in cell voltage, and FIG. 7B is a graph illustrating the variation in charging current.

However, even if a voltage of 4.2 V is applied, as mentioned hereinabove, the voltage that actually contributes to charging is less than this value due to the effect of internal resistance, and the battery actually cannot be charged up to a full charge. Accordingly, as described in Patent Document 1 that is a typical representative of related art, where the cell voltage increases to a certain degree in high-current (CC) charging, a switch of a serial circuit composed of the switch and a resistor and provided in parallel to each cell is switched ON. As the charging advances, a current flows in the bypass path, thereby reducing the effect of the internal voltage and ensuring full charging. Patent Document 2 describes a configuration in which an electric current I is reduced each time a battery pack voltage reaches a voltage equal to Vf(voltage of the battery) + R (resistance other than that inside the battery, for example, of a protective element) × I (charging current).

The problem associated with the above-described conventional related art is that charging is performed up to a full charge, while preventing overcharge, by substantially reducing the charging current in the final period of charging and, therefore, the reduction of charging time is insufficient.

　　Patent Document 1: Japanese Patent Laid-Open No. H11-285162
　　Patent Document 2: Japanese Patent Laid-Open No. 2005-185060.

Disclosure of the Invention

It is an object of the present invention to provide a quick charging method of a lithium-based secondary battery by which quick charging up to a full charge can be performed, while preventing overcharging.

An electronic device according to one aspect of the present invention includes: a lithium-based secondary battery; a charging current supply unit for quickly charging the lithium-based secondary battery; a charging control unit that controls a charging current supplied by the charging current supply unit; a temperature detection unit that detects a temperature of the lithium-based secondary battery; a voltage detection unit that detects a terminal voltage of the lithium-based secondary battery; and a setting unit that sets a charge end voltage in the charging control unit, wherein the charging control unit causes the charging current supply unit to supply a predetermined constant quick charging current to the lithium-based secondary battery and ends the supply of the quick charging current when the terminal voltage detected by the voltage detection unit becomes the charge end voltage that has been set by the setting unit, and the setting unit includes: an internal resistance estimation unit that estimates an internal resistance value of the secondary battery from a temperature of the lithium-based secondary battery detected by the temperature detection unit; and a charge end voltage calculation unit that estimates a voltage drop amount caused by the internal resistance from the internal resistance value estimated by the internal resistance estimation unit and the quick charging current value and calculates the charge end voltage by adding the voltage drop amount to a preset reference voltage.

A quick charging method of a lithium-based secondary battery according to one aspect of the present invention is a method for quickly charging the lithium-based secondary battery to a predetermined charge end voltage, including: a step of continuously supplying a predetermined constant quick charging current; a step of detecting at least a temperature of the secondary battery; a step of estimating an internal resistance value of the secondary battery from the detected temperature; a step of estimating a voltage drop amount caused by the internal resistance from the estimated internal resistance value and the quick charging current value; and a step of calculating the charge end voltage by adding the voltage drop amount to a preset reference voltage.

With the quick charging method of a lithium-based secondary battery according to one aspect of the present invention and the electronic device using same, the charging current is maintained at a predetermined constant quick charging current and the charging is ended when the terminal voltage reaches the charge end voltage, instead of the conventional CC-CV charging. Further, the charge end voltage is taken as a voltage obtained by adding a voltage drop amount that is obtained by multiplying an internal resistance value estimated from the temperature of the secondary battery by the quick charging current value to a predetermined reference voltage.

Therefore, a constant high current can be supplied from the beginning of charging to the end and quick charging can be performed, while preventing overcharge.

Brief Description of the Drawings

[Fig. 1] FIG. 1 is a block diagram illustrating the electric configuration of the electronic device of Embodiment 1 of the present invention.

[Fig. 2] FIG. 2 is a graph for explaining how the internal resistance value changes with the temperature of a nonaqueous electrolyte secondary battery having a heat-resistance layer composed of a porous protective film including a resin adhesive and an inorganic oxide filler between a negative electrode and a positive electrode.

[Fig. 3] FIG. 3 is a flowchart for explaining in details the charging operation in the electronic device according to Embodiment 1 of the present invention.

[Fig. 4] FIG. 4 is a graph for explaining the charging method according to Embodiment 1 of the present invention. FIG. 4A is a graph illustrating the cell voltage variations, and FIG. 4B is a graph illustrating the charging current variations.

[Fig. 5] FIG. 5 is a flowchart for explaining in details the charging operation in the electronic device according to Embodiment 2 of the present invention.

[Fig. 6] FIG. 6 is a graph illustrating how the internal resistance value changes as the SOC changes.

[Fig. 7] FIG. 7 is a graph for explaining the representative conventional charging method. FIG. 7A is a graph illustrating the cell voltage variations, and FIG. 7B is a graph illustrating the charging current variations.

[Fig. 8] FIG. 8 is a block diagram illustrating one electric configuration example of the electronic device of Embodiment 3 of the present invention.

[Fig. 9] FIG. 9 is a flowchart illustrating one operation example of the electronic device shown in FIG. 8.

[Fig. 10] FIG. 10 is a block diagram illustrating one electric configuration example of the electronic device of Embodiment 4 of the present invention.

[Fig. 11] FIG. 11 is a flowchart illustrating one operation example of the electronic device shown in FIG. 10.

[Fig. 12] FIG. 12 is a flowchart illustrating one operation example of the electronic device shown in FIG. 10.

[Fig. 13] FIG. 13 is a flowchart illustrating one operation example of the electronic device shown in FIG. 10.

[Fig. 14] FIG. 14 is a block diagram illustrating a modification example of the electronic device shown in FIG. 10.

Best Mode for Carrying Out the Invention

Embodiment 1

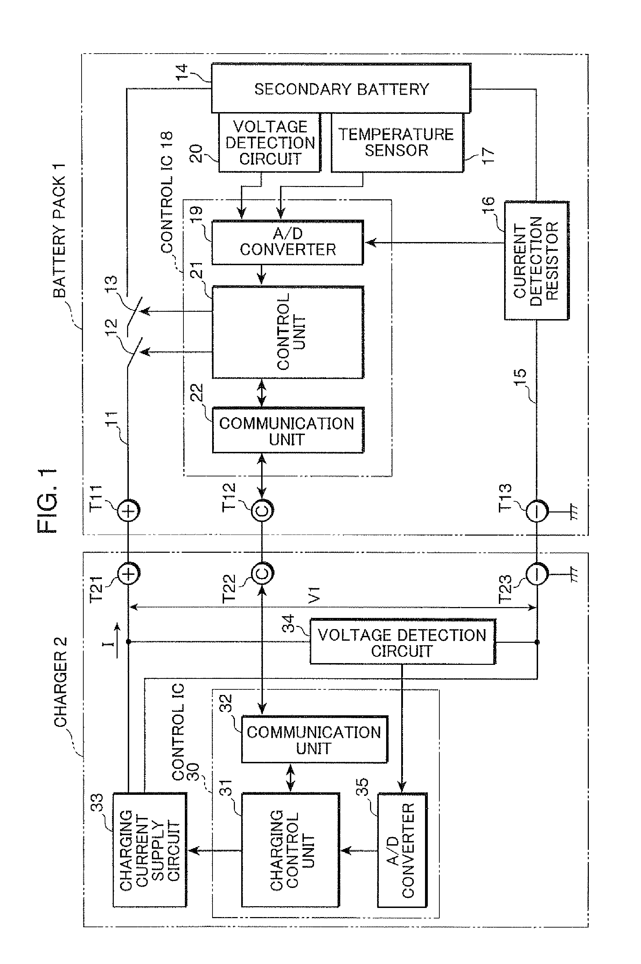

FIG. 1 is a block diagram illustrating the electric configuration of the electronic device of Embodiment 1 of the present invention. This electronic device is constituted by providing a charger 2 that charges a battery pack 1 and a load device (not shown in the figure) in the battery pack. In the configuration shown in FIG. 1, the battery pack 1 is charged from the charger 2, but it is also possible to mount the battery pack 1 on the load device and charge the battery pack via the load device. The battery pack 1 and charger 2 are connected to each other by terminals T11, T21 on the DC-high side that conduct power supply, terminals T12, T22 for communication signals, and GND terminals T13, T23 for power supply and communication signals. Same terminals are provided even when the load device is not provided.

FET 12, 13 that have mutually different conductivity modes for charging and discharging are introduced in a charge-discharge path 11 on a DC-high side that extends from the terminal T11 inside the battery pack 1, and this charge-discharge path 11 is connected to a high-side terminal of a secondary battery 14. One terminal of the secondary terminal is connected to the GND terminal T 13 via a charge-discharge path 15 on a DC-low side, and a current detection resistor 16 that converts a charging current and a discharging current into a voltage value is introduced in the charge-discharge path 15.

The secondary battery 14 includes one cell or a plurality of cells connected in series; the cell temperature is detected by a temperature sensor 17 and inputted in an analog/digital converter 19 contained in a control IC 18. A voltage between the terminals of each cell is detected by a voltage detection circuit 20 and inputted in the analog/digital converter 19 contained in the control IC 18. Furthermore, a current value detected by the current detection resistor 16 is also inputted in the analog/digital converter 19 contained in the control IC 18. The analog/digital converter 19 converts the inputted values into digital values and outputs them to a control unit 21.

The control unit 21 is constituted by providing a microcomputer and peripheral circuits thereof. The control unit 21 functions as a SOC acquisition unit by executing a predetermined control program.

In response to the inputted values from the analog/digital converter 19, the control unit 21 integrates the current values detected by the current detection resistor 16 or recalculates the terminal voltage detected by the voltage detection circuit 20 as a SOC, thereby calculating the residual charge (SOC) of the secondary battery 14. The control unit 21 transmits information indicating whether the voltage and temperature of each cell are normal or abnormal from a communication unit 22 to the charger 2 via the terminals T12, T22, T13, and T23. When charging and discharging are performed normally, the control unit 21 switches the FET 12 and 13 ON and enables charging and discharging, and when an abnormality is detected, the control unit switches the transistors OFF and prohibits charging and discharging.

In the charger 2, the signal indicating temperature or presence of abnormality is received by a communication unit 32 of a control IC 30, and the charging control unit 31 controls the charging current supply circuit 33 and causes the supply of a charging current. The charging current supply circuit 33 is constituted by an AC-DC converter or a DC-DC converter. The charging current supply circuit 33 converts the input voltage supplied from the outside into a predetermined voltage value and a current value and supplies these values to the charge-discharge paths 11, 15 via the terminals T21, T11, T23, and T13.

The charging control unit 31 is constituted, for example, by a CPU (Central Processing Unit) that executes predetermined operational processing, a ROM (Read Only Memory) that stores a predetermined control program, a RAM (Random Access Memory) that temporarily stores data, and peripheral circuits of the above-listed components. By executing the control program stored in the ROM, the charging control unit 31 functions as a setting unit including an internal resistance estimation unit and a charge end voltage calculation unit.

The following features are of importance in the electronic device of the above-described configuration. Thus, in the present embodiment, when quick charging of the secondary battery 14 is conducted, the charging control unit 31 monitors a voltage V1 between the terminals T21 (T11) and T23 (T13), which is detected by the voltage detection circuit 34, via the analog/digital converter 35, while the predetermined constant quick charging current I is being supplied by the charging current supply circuit 33. Where the voltage V1 reaches a predetermined charge end voltage Vf, the supply of quick charging current I by the charging current supply circuit 33 is ended.

Thus, it is noteworthy that charging is ended as the CC (constant current) charging, without performing the CV (constant voltage) charging after the CC (constant current) charging, as in the conventional process, and that the voltage Vf at which the charging is ended is determined correspondingly to a cell temperature T that is detected by the temperature sensor 17 and inputted via the communication units 22, 32.

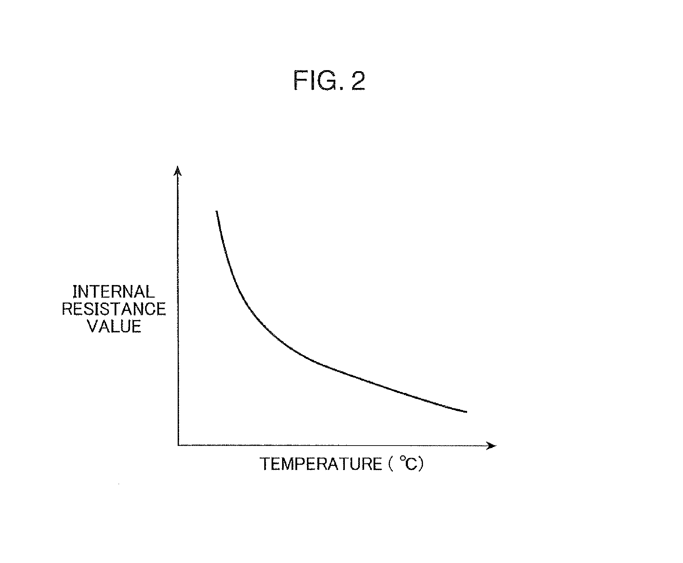

More specifically, as shown in FIG. 2, the charging control unit 31 stores data on an internal resistance value R of the secondary battery 14 that decreases with the increase in temperature T, for example, in a nonvolatile storage element such as a ROM. The data are stored in advance in the form of a data table. Where the temperature data are inputted from the battery pack 1, the charging control unit 31 reads the internal resistance value R corresponding thereto from the table. Where no corresponding data are present in the data table, the corresponding data may be found by interpolating the preceding and subsequent data, or the internal resistance value R may be found by storing an equation approximating the relationship between the internal resistance value R and temperature T and conducting successive computations each time the temperature data are inputted.

The charging control unit 31 (internal resistance estimation unit) then estimates a voltage drop amount VD caused by the internal resistance by multiplying the found internal resistance value R by the quick charging current value 1. The charging control unit 31 (charge end voltage calculation unit) then sets as a charge end voltage a voltage Vf obtained by adding the voltage drop amount VD to the initial charge end voltage Vf (reference voltage).

An open-circuit voltage (OCV) in a fully charged state of the secondary battery 14, that is, a full charge voltage is set in advance as an initial charge end voltage Vf.

In a case where the secondary battery 14 is a lithium ion secondary battery, for example, a difference between a positive electrode potential and a negative electrode potential, that is, an terminal voltage of the secondary battery 14, at the time the negative electrode potential of the secondary battery 14 is substantially 0 V is used as the full charge voltage. In a case of a lithium ion secondary battery, the full charge voltage is about 4.2 V when lithium cobalt oxide is used as the positive electrode active materials and about 4.3 when lithium manganese oxide is used as the positive electrode active material.

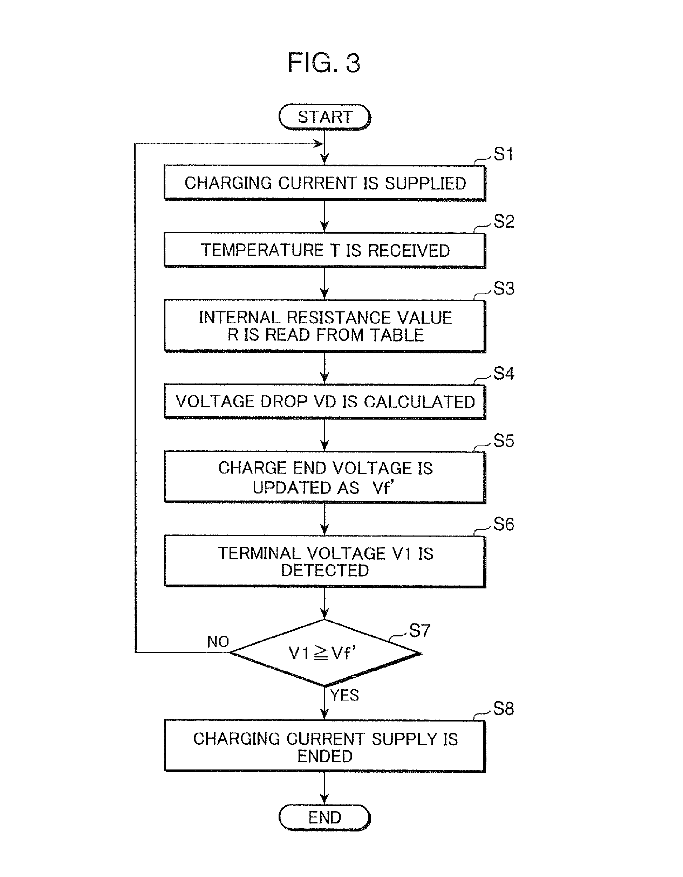

FIG. 3 is a flowchart explaining in details such a charging operation performed by the charging control unit 31. The charging control unit 31 starts the supply of the quick charging current I in step S1 and receives data on the temperature T from the battery pack 1 in step S2. In step S3, the charging control unit 31 finds the internal resistance value R corresponding to the received data by reading from the data table or calculations. Then the charging control unit finds the voltage drop amount VD caused by the internal resistance from $I \times R$ in step S4 and then finds the charge end voltage Vf from Vf + VD in step S5.

In step S6, the charging control unit 31 detects an actual terminal voltage V1, and in step S7 the charging control unit determines whether the voltage V1 is equal to or higher than the charge end voltage Vf. When the voltage V1 is determined in step S7 not to be equal to or higher than the charge end voltage Vf, the charging control unit 31 returns to step S1 and continuous charging at a high current I. Where the voltage V1 is determined to be equal to or higher than the charge end voltage Vf, the charging control unit 31 advances to step S8 stops the supply of the charging current I and, when an indicator is present, performs a full charge display.

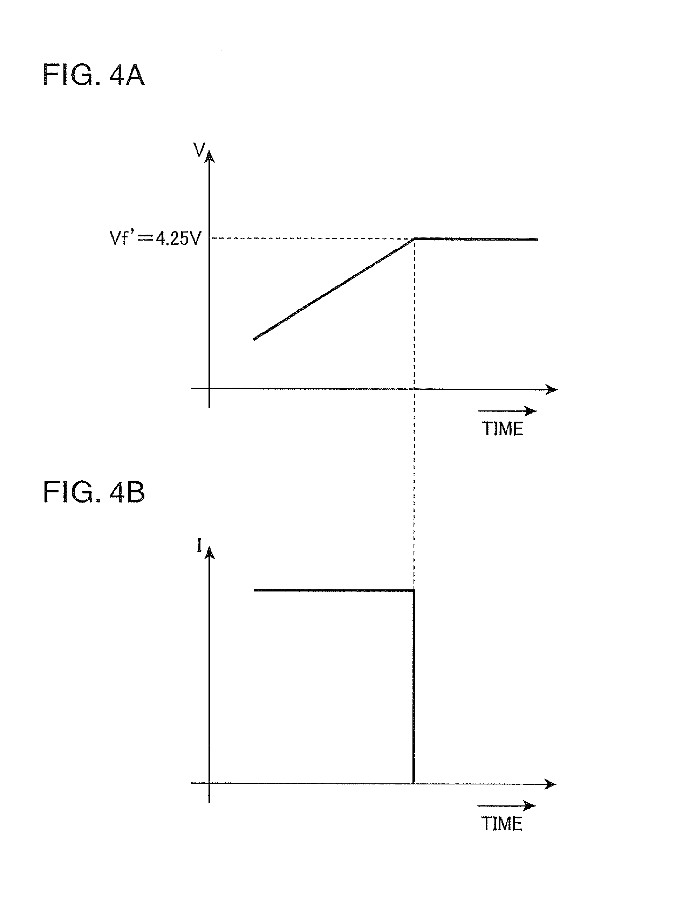

Therefore, for example, in a case of lithium ion secondary battery, the initial charge end voltage Vf is typically set to 4.2 V or 4.25 V per cell, whereas in the present embodiment, for example, this voltage is set to 4.25 V or 4.3 V, for example, when I = 2A and R = 25 m$\Omega$, with consideration for the voltage drop amount VD caused by internal resistance. With such a configuration, quick charging can be performed till the full charge state is assumed by supplying a constant high current I from the beginning to the end, while preventing overcharging. FIG. 4 illustrates a charging method according to the present embodiment of the above-described configuration. Similarly to FIG. 7, FIG. 4A is a graph illustrating the cell voltage variations, and FIG. 4B is a graph illustrating the charging current variations.

Further, the secondary battery 14 is preferably a nonaqueous electrolyte secondary battery having a heat-resistant layer composed of a porous protective film including a resin adhesive and an inorganic oxide filler between a negative electrode and a positive electrode. Such a secondary battery is disclosed, for example, in Japanese Patent No. 3371301. The inorganic oxide filler can be selected from an alumina powder or a $SiO_2$ powder (silica) with a particle size within a range of from 0.1 $\mu$m to 50 $\mu$m. The thickness of the porous protective film is set to 0.1 $\mu$m to 200 $\mu$m. The porous protective film is configured by coating a fine particle slurry including a resin adhesive and an inorganic oxide filler on at least one surface of the negative electrode or positive electrode.

Where the secondary battery of such a configuration is used, even if an overcharged state is assumed and metallic lithium precipitates in the dendritic form, the heat-resistant layer can prevent a short circuit between the negative electrode and positive electrode. Therefore, such a secondary battery is especially advantageous for the above-described quick charging with a constant high current I.

Embodiment 2

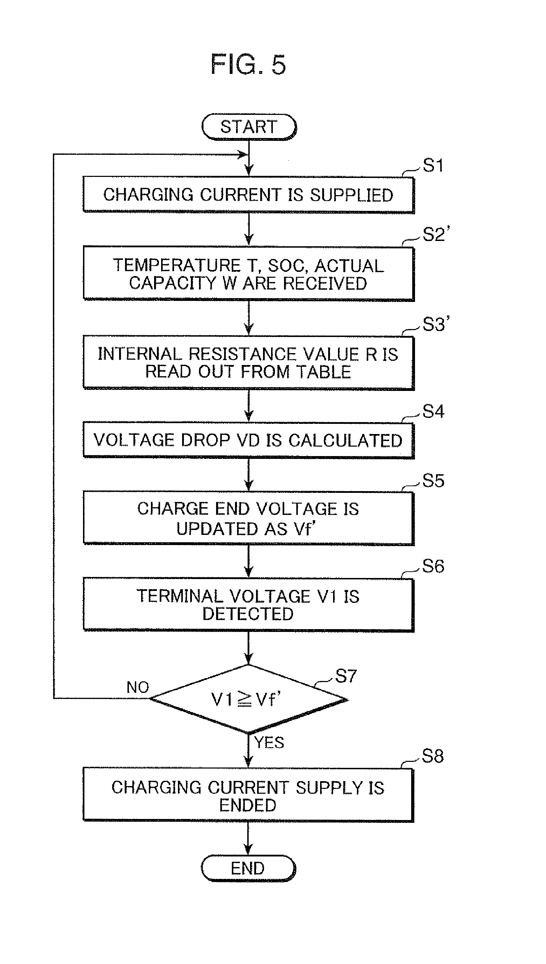

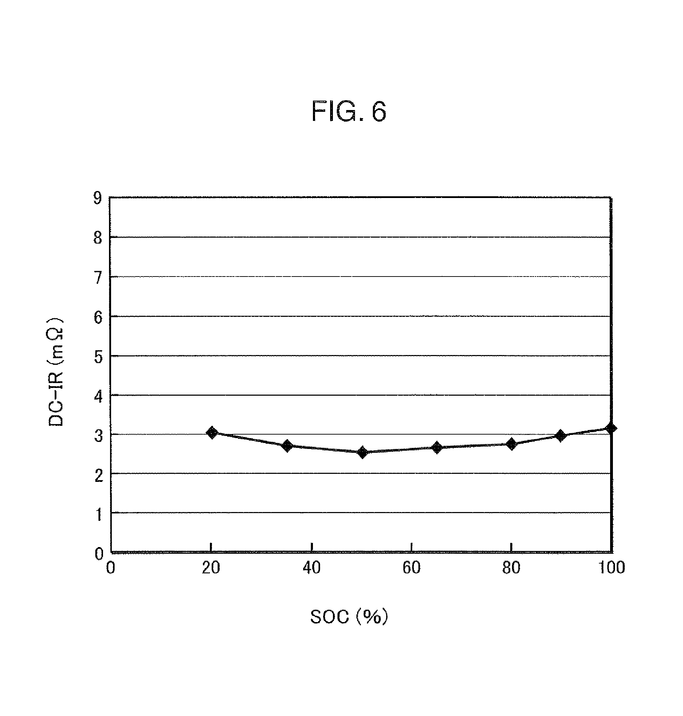

FIG. 5 is a flowchart illustrating in detail the charging operation in the electronic device according to Embodiment 2 of the present invention. In this embodiment, the above-described configuration of electronic device shown in FIG. 1 can be used. The processing illustrated by FIG. 5 is similar to the above-described processing illustrated by FIG. 3, and the corresponding portions are assigned with identical step numbers and explanation thereof is herein omitted. A noteworthy feature of the present embodiment, it that that the charge end voltage Vf is determined not only by the internal resistance value R, but also by taking into account the terminal voltage V1 and actual capacity W of the secondary battery 14. As shown in FIG. 2, the internal resistance value R (DC-IR) not only decreases with the increase in temperature, but also changes depending on SOC (State of Charge), as shown in FIG. 6. Further, the internal resistance value R increases as the deterioration advances due to repeated charging and discharging.

Therefore, in step S2', the charging control unit 31 takes in not only data on the cell temperature T, but also data on SOC (= terminal voltage) integrated by the control unit 21 and data on actual capacity (Ah in a fully charged state) W (= degree of deterioration) that decreased due to repeated charging and discharging managed by the control unit 21. Then, in step S3', the charging control unit 31 reads a table in which the corresponding internal resistance value has been stored by taking all these data as parameters, or reads a data table in which the corresponding internal resistance value has been stored by taking some of these data as parameters, and then creates the values to be used after correcting the read-out data with the remaining parameters, thereby finding the internal resistance value R.

By taking into account not only the cell temperature T, but also the SOC (= terminal voltage) and actual capacity W (= degree of deterioration) when the internal resistance value R is thus evaluated, it is possible to find the internal resistance value R, that is, the charge end voltage Vf, more accurately.

The terminal voltage V1 may be found by sending data detected by the voltage detection circuit 20 on the battery pack 1 side to the charger 2 side, rather than by detection with the voltage detection circuit 34. Further, in a lithium-based secondary battery, the terminal voltage V1 increases with the increase in SOC. Therefore, the terminal voltage V1 may be also used to represent the SOC value.

In the above-described embodiment, the analog/digital converter 19 is mounted on the battery pack 1 side and information on the battery temperature and battery voltage is transmitted to the charging control unit 31 on the charger 2 side via the communication units 22, 32. However, it is also possible to mount the analog/digital converter on the charging control unit 31 side and directly read the information. Furthermore, in the above-described embodiment, the charging control unit 31 is provided separately from the battery pack 1, but a battery pack having a charging control function in which the charging control unit 31 is integrated with the battery pack 1 may be also used.

Japanese Patent Application Laid-open No. 2005-261020 discloses a configuration in which a difference in voltage between an OCV (open-circuit voltage) and CCV (closed-circuit voltage) is found each time charging is performed, a time in which the terminal voltage rises by this differential voltage in the constant-current charging process is measured, and even if the predetermined charge end voltage is reached, the charging is continued from this point in time for the measured time, whereby quick charging is performed up to a full charge, without being affected by internal resistance. In such a configuration process, the OCV and CCV measured immediately before the terminal voltage reaches the charge end voltage indicate the adjustment to variations in the internal resistance value that follows the increase in temperature caused by charging.

However, with such a conventional process, although charging to a full charge can be performed, while preventing overcharging, and the charging time can be shortened by switching from the conventional CV charging to CC charging, a period in which the charging current does not flow is required for OCV measurements and the charging time is extended with respect to that of the present embodiment.

With this issue in view, Japanese Patent Application Laid-open No. H 10-214643 discloses a process in which the charging current is oscillated, the internal resistance is measured from the preceding and following voltage and current values, and the voltage corresponding to a voltage drop caused by the internal resistance is added to the charging voltage. Therefore, it is not necessary to stop completely the charging current to conduct OCV measurements and the charging time can be reduced to a certain degree, but because the charging current is reduced to below the CC level, the charging time is obviously longer than that in the embodiment in which charging is performed at a constant CC level from the beginning to the end.

Embodiment 3

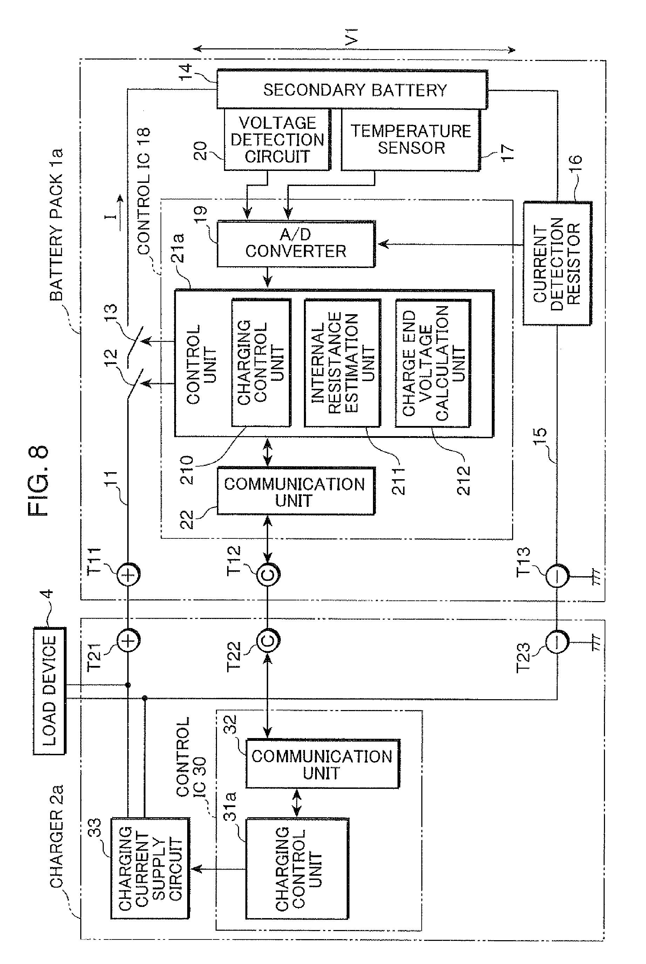

FIG. 8 is a block diagram illustrating a configuration example of the electronic device of Embodiment 3 of the present invention. In FIG. 8, components identical to those of the electronic device shown in FIG. 1 are assigned with identical reference numerals and explanation thereof is omitted. The electronic device shown in FIG. 8 differs from the electronic device shown in FIG. 1 in the aspects as follows. Thus, in the electronic device shown in FIG. 8, a control unit 21a functions as a charging control unit 210, an internal resistance estimation unit 211, and a charge end voltage calculation unit 212.

The charging control unit 31a dose not performs the detection of the internal resistance value R, setting of the charge end voltage, and determination of charge end. Further, a load device 4 is connected between a terminal T21 and a terminal T23. The discharge current of the secondary battery 4 and the current outputted from the charging current supply circuit 33 is supplied as a drive current of the load device 4.

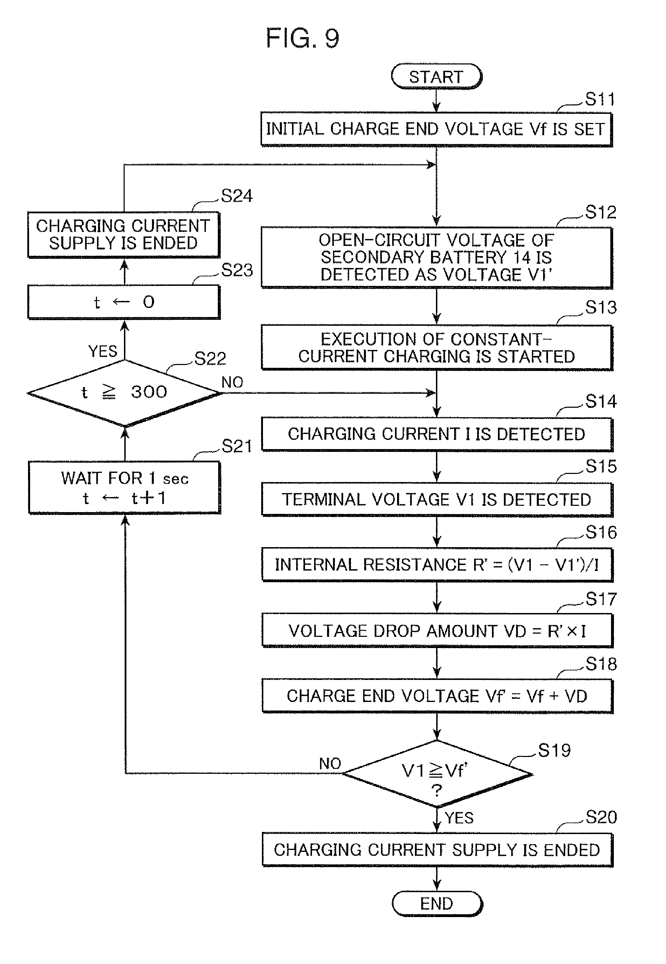

FIG. 9 is a flowchart illustrating an operation example of the electronic device shown in FIG. 8. In the flowchart described below, like operations are assigned with like step numbers and explanation thereof is omitted. First, for example, a full charge voltage of the secondary battery 14 is initially set as an initial charge end voltage Vf by the charge end voltage calculation unit 212 (step S11). Then, the internal resistance estimation unit 211 acquires the terminal voltage V1 detected by the voltage detection circuit 20 as the open-circuit voltage V1' (step S12).

Then, the internal resistance estimation unit 211 requests a current output of the predetermined current value I (quick charging current) to the charging control unit 31a via the communication units 22 and 32. As a result, a charging current of a current value I is supplied from the charging current supply circuit 33 to the secondary battery 14 and constant-current charging is started in response to the control signal from the charging control unit 31a (step S13).

Then, the internal resistance estimation unit 211 acquires the current value I detected by a current detection resistor 16 and the terminal voltage V1 detected by the voltage detection circuit 20 (step S14, S15). The internal resistance value R' is then calculated based on the following Equation (1) (step S16).

$$R' = (V1 - V1')/I \qquad \dots (1)$$

The charge end voltage calculation unit 212 then calculates the voltage drop amount VD on the basis of the following Equation (2) (step S17).

$$VD = R' \times I \qquad \dots (2)$$

The charge end voltage calculation unit 212 then calculates and sets the charge end voltage Vf' on the basis of the following Equation (3) (step S18).

$$Vf' = Vf + VD \qquad \ldots(3)$$

The charging control unit 210 then compares the terminal voltage V1 with the charge end voltage Vf (step S19). Where the terminal voltage V1 is equal to or higher than the charge end voltage Vf (YES in step S19), the charging control unit 210 transmits a charge end instruction signal to the charging control unit 31a. As a result, the charging current supply circuit 33 stops the supply of charging current in response to the control signal from the charging control unit 31a and ends the charging (step S20).

Where the terminal voltage V1 is determined in step S19 to be less than the charge end voltage Vf' (NO in step S19), the charging control unit 210 adds 1 to a variable t for waiting for 1 sec and counting the time (step S21).

After 1 sec has elapsed, the charging control unit 210 compares the variable t with 300 (step S22). Where the variable t is less than 300 (NO in step S22) and 5 min have not elapsed, the steps S14 to S19 are repeated each minute, and charge end determination is executed in step S19, while updating the charge end voltage Vf'.

Where the variable t is equal to or more than 300 (YES in step S22) and 5 or more minutes have elapsed, the charging control unit 210 initializes the variable t (step S23) and sends an instruction signal requesting that the charging current be made zero to the charging control unit 31a. As a result, the charging current supply circuit 33 stops the supply of charging current in response to the control signal from the charging control unit 31a (step S24). Then, steps S12 to S19 are repeated again and the open-circuit voltage V1' is measured again, the charge end voltage Vf' is updated and charge end determination in step S19 is executed, while correcting the variation of the open-circuit voltage V1' caused, for example, by changes in temperature environment.

Embodiment 4

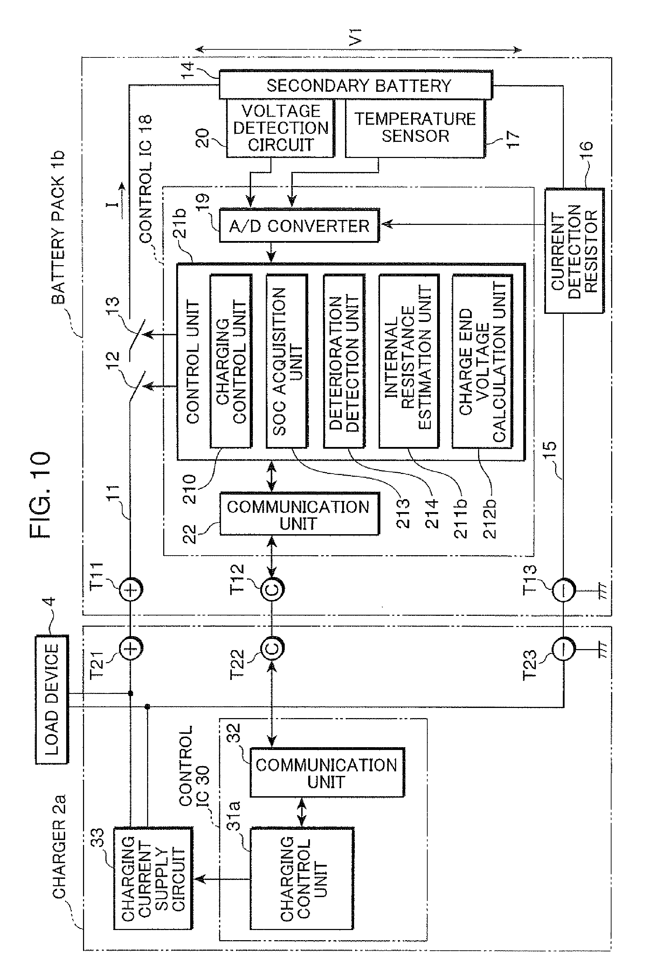

FIG. 10 is a block diagram illustrating a configuration example of the electronic device of Embodiment 4 of the present invention. In FIG. 10, components identical to those of the electronic devices shown in FIG. 1 and FIG. 8 are assigned with identical reference numerals and explanation thereof is omitted. The electronic device shown in FIG. 10 differs from the electronic device shown in FIG. 8 in the aspects as follows. Thus, in the electronic device shown in FIG. 10, a control unit 21b further functions as a SOC acquisition unit 213 and a deterioration detection unit 214. Furthermore, the deterioration detection unit 214 functions as an OCV acquisition unit, a CCV acquisition unit, and an actual internal resistance calculation unit. In addition, the internal resistance estimation unit 211b and charge end voltage calculation unit 212b in the present embodiment operate differently. The control unit 21b is provided with a nonvolatile storage element such as a ROM that stores in advance a data table representing a correspondence relationship of the temperature T of the secondary battery 14, SOC, and internal resistance value R of the secondary battery 14.

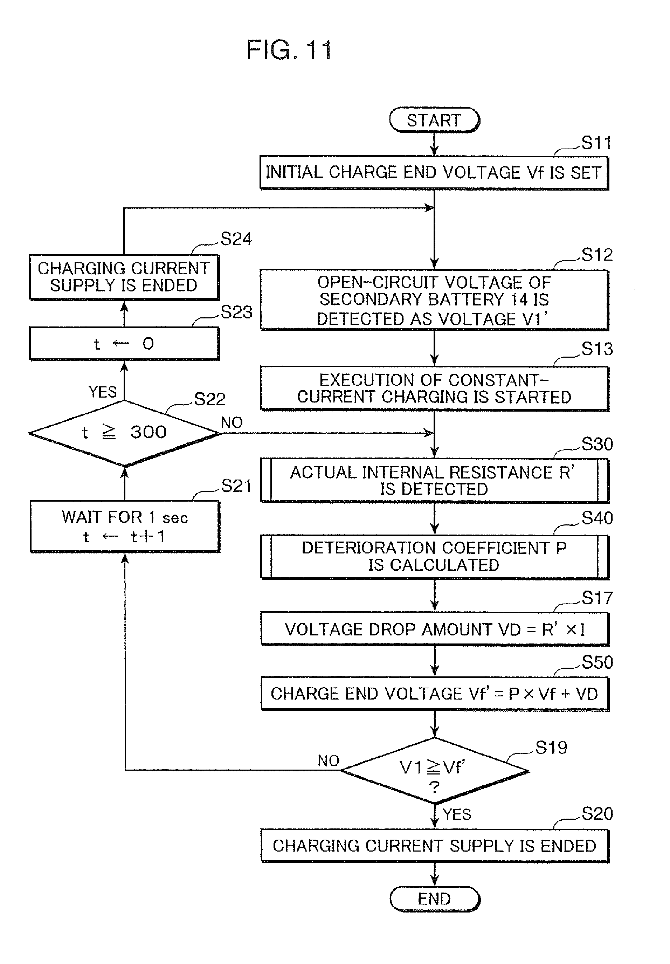

Other features are identical to those of the electronic device shown in FIG. 9 and the explanation thereof is herein omitted. Specific operation of the electronic device shown in FIG. 10 will be explained below. FIG. 11, FIG. 12, and FIG. 13 are flowcharts illustrating an operation example of the electronic device shown in FIG. 10.

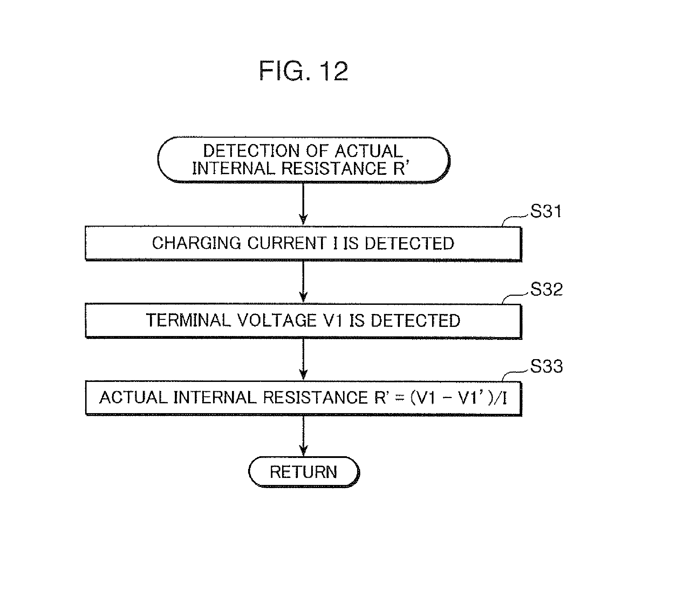

After steps S11 to S13 have been executed in the same manner as in the flowchart shown in FIG. 8, the actual internal resistance value R' which is the actual internal resistance value of the secondary battery 14 is detected by the deterioration detection unit 214 (actual internal resistance calculation unit). FIG. 12 is a flowchart showing an example of detecting the actual internal resistance value R'.

The deterioration detection unit 214 acquires the current value I detected by the current detection resistance 16 (step S31). Further, the deterioration detection unit 214 (CCV acquisition unit) acquires the terminal voltage V1 detected by the voltage detection circuit 20 as a closed-circuit terminal voltage (step S32). The deterioration detection unit 214 (OCV acquisition unit) also acquires the open-circuit voltage VI' detected in step S12 as an open-circuit terminal voltage.

The deterioration detection unit 214 (actual internal resistance calculation unit) then calculates the internal resistance value R' on the basis of Equation (4) below and ends the operation of detecting the actual internal resistance value R' (step S33).

$$R' = (V1 - V1')/I \qquad \ldots(4)$$

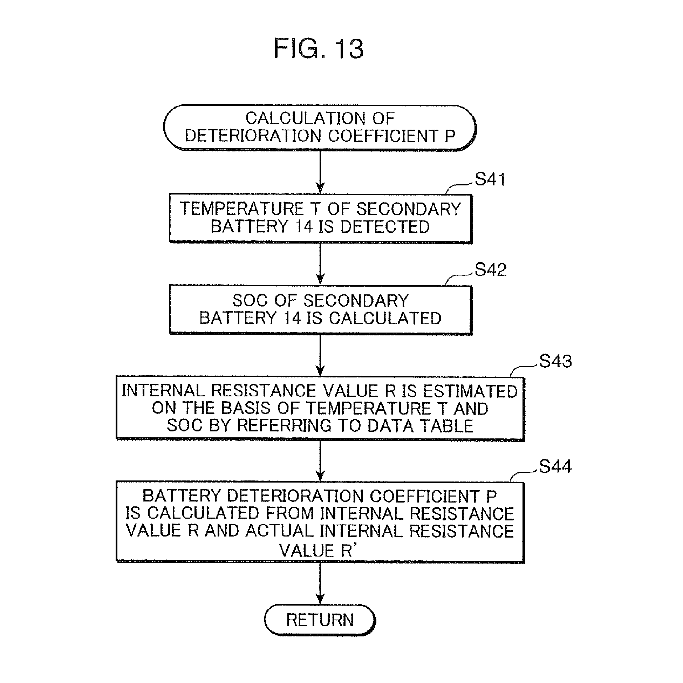

Returning to FIG. 11, a deterioration coefficient P is then calculated (step S40). FIG. 13 is a flowchart showing an example of calculating the deterioration coefficient P. First, the temperature T of the secondary battery 14 is detected by the temperature sensor 17 (step S41). Then, SOC of the secondary battery 14 is calculated by the SOC acquisition unit 213 (step S42).

The SOC acquisition unit 213 may calculate the SOC of the secondary battery 14, for example, by all-time integration of the charging-discharging current detected by the current detection resistor 16, or may calculate the SOC by recalculating the terminal voltage V1 of the secondary battery 14 detected by the voltage detection circuit 20 into the SOC.

Then, the internal resistance estimation unit 211b acquires the internal resistance value R associated with the temperature T and SOC acquired in steps S41 and S42, for example, from the data table stored in the ROM (step S43).

As a result, because the internal resistance value R corresponds to the internal resistance value at the time when the secondary battery 14 has not deteriorated, the difference between the internal resistance value R and the actual internal resistance value R' increases as the deterioration of the secondary battery 14 advances.

The deterioration degree P is calculated by a deterioration degree calculation unit 214 so that a larger level of deterioration is shown as the difference between the internal resistance value R and the actual internal resistance value R' increases, for example, as the R/R' ratio decreases (step S44).

More specifically, the deterioration degree P is acquired, for example, by using a preset function or a data table, so that the numerical value of the deterioration degree is equal to or less than "1' and decreases with the decrease in R/R' ratio.

Further, returning to FIG. 11, the charge end voltage Vf' is calculated by the charge end voltage calculation unit 212b on the basis of the following Equation (5) (step S50).

$$Vf' = P \times Vf + VD \qquad\qquad ...(5)$$

The charge end voltage Vf' is thus corrected so that the charge end voltage decreases with the increase in the level of deterioration represented by the deterioration degree P.

The deterioration of a lithium-based secondary battery advances easily when the charging voltage increases as the deterioration advances. Therefore, assuming that charging has been conducted to a constant end voltage, regardless of the level of deterioration of a lithium-based secondary battery, the progress in deterioration will increase and deterioration will be accelerated in a battery with advanced deterioration. However, with the electronic device shown in FIG. 10, because the charge end voltage Vf is corrected so that the charge end voltage Vf decreases as the level of deterioration represented by the deterioration degree P increases, the possibility of the deterioration of the secondary battery 14 accelerating is reduced.

The operation of subsequent steps S19 to S24 is similar to that illustrated by the flowchart shown in FIG. 9 and explanation thereof is omitted.

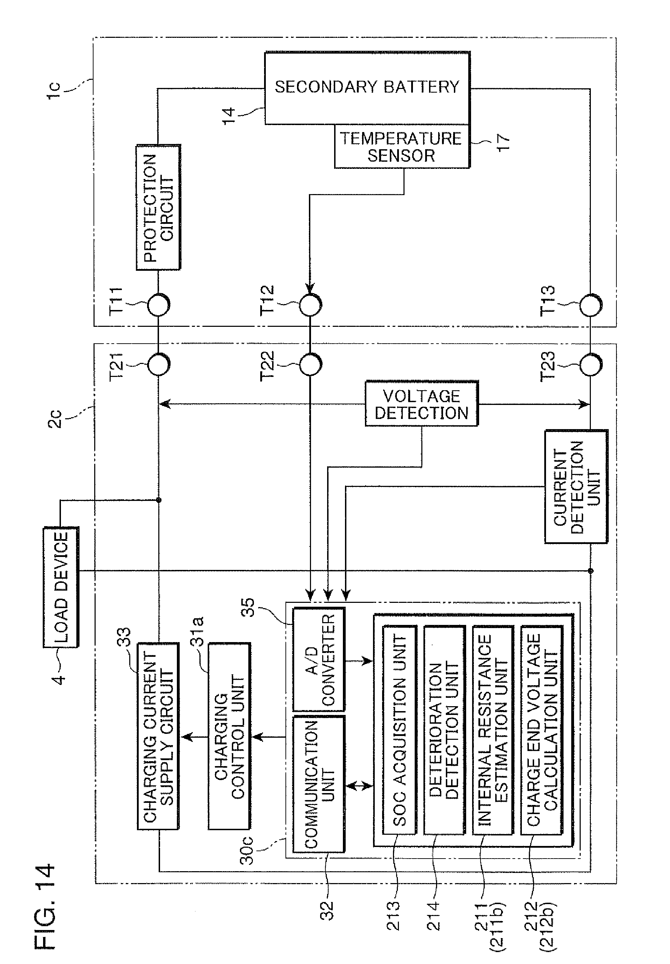

Further, for example, as shown in FIG. 14, a configuration may be also used in which at least some units from among the SOC acquisition unit 213, deterioration detection unit 214, internal resistance estimation unit 211 (211b), and charge end voltage calculation unit 212 (212b) are provided in a charger 2c.

Thus, an electronic device according to one aspect of the invention includes: a lithium-based secondary battery; a charging current supply unit for quickly charging the lithium-based secondary battery; a charging control unit that controls a charging current supplied by the charging current supply unit; a temperature detection unit that detects a temperature of the lithium-based secondary battery; a voltage detection unit that detects a terminal voltage of the lithium-based secondary battery; and a setting unit that sets a charge end voltage in the charging control unit, wherein the charging control unit causes the charging current supply unit to supply a predetermined constant quick charging current to the lithium-based secondary battery and ends the supply of the quick charging current when the terminal voltage detected by the voltage detection unit becomes the charge end voltage that has been set by the setting unit, and the setting unit includes: an internal resistance estimation unit that estimates an internal resistance value of the secondary battery from a temperature of the lithium-based secondary battery detected by the temperature detection unit; and a charge end voltage calculation unit that estimates a voltage drop amount caused by the internal resistance from the internal resistance value estimated by the internal resistance estimation unit and the quick charging current value and calculates the charge end voltage by adding the voltage drop amount to a preset reference voltage.

A quick charging method of a lithium-based secondary battery according to one aspect of the present invention is a method for quickly charging the lithium-based secondary battery to a predetermined charge end voltage, including a step of continuously supplying a predetermined constant quick charging current; a step of determining at least a temperature of the secondary battery; a step of estimating an internal resistance value of the secondary battery from the detected temperature; a step of estimating a voltage drop amount caused by the internal resistance from the estimated internal resistance value and the quick charging current value; and a step of calculating the charge end voltage by adding the voltage drop amount to a preset reference voltage.

With such features, in the quick charging method of a secondary battery such as a lithium-based secondary battery for which a conventional standard charging method involves CC (constant current) charging to a predetermined charge end voltage and then switching to CV (constant voltage) charging after the charge end voltage has been assumed, and in an electronic device using the quick charging method, the charging control unit maintains the charging current supplied from the charging current supply unit to the battery pack at a predetermined constant quick charging current when quick charging is realized.

When the end voltage detected by the voltage detection unit reaches the charge end voltage, the charging control unit determines that the secondary battery has been fully charged and stops the supply of the quick charging current with the charging current supply unit. The charge end voltage is usually appropriately set correspondingly to the battery temperature or ambient temperature and is not a fixed value, but in accordance with the present invention, the charge end voltage is set by taking into account the voltage drop caused by internal resistance. Variations in the internal resistance caused by temperature (internal resistance deceases with the increase in temperature) is compensated.

More specifically, the setting unit estimates the internal resistance value of a secondary battery on the basis of secondary battery temperature detected by the temperature detection unit, estimates the voltage drop amount caused by the internal resistance from the estimated internal resistance value and a predetermined quick charging current value, and calculates and sets the charge end voltage by adding the voltage drop amount to the preset reference value.

Therefore, charging is performed till the terminal voltage of the secondary battery becomes higher than the reference voltage by a voltage corresponding to the amount of voltage drop that occurs because the charging current flows through the internal resistance of the secondary battery. As a result, the open-circuit voltage of the secondary battery exceeds the reference voltage and is prevented from causing overcharge. Therefore, quick charging can be performed by supplying a constant high current from the beginning to the end, while preventing overcharge. Further, because the internal resistance value is estimated based on the secondary battery temperature, it is not necessary to interrupt the charging to measure the internal resistance value. Therefore, the possibility of charging time being extended due to measurements of the internal resistance value is reduced.

Further, the reference voltage is preferably an open-circuit voltage when the lithium-based secondary battery is fully charged.

With such a configuration, the lithium-based secondary battery is constant-current charged at a constant charging current till the battery is fully charged. Therefore, the charging time can be shortened.

Further, the lithium-based secondary battery is preferably a nonaqueous electrolyte secondary battery having a heat-resistance layer between a negative electrode and a positive electrode.

The heat-resistant layer is preferably a porous protective film including a resin adhesive and an inorganic oxide filler.

Such a configuration is advantageous for quick charging at a constant current in a nonaqueous electrolyte secondary battery having a heat-resistance layer composed of a porous protective film including a resin adhesive and an inorganic oxide filler between a negative electrode and a positive electrode because even if an overcharged state is assumed and metallic lithium precipitates in the dendritic form, the heat-resistant layer can prevent a short circuit between the negative electrode and positive electrode.

In particular, when a full charge voltage, which is an open-circuit voltage when the lithium-based secondary battery is fully charged, is set as the reference voltage, because charging is so performed that the closed-circuit voltage of the lithium-based secondary battery exceeds the full charge voltage, the charging voltage becomes higher than that of the conventional charging method by which constant current charging is performed at a full charge voltage. However, by providing the heat-resistant layer, it is possible to ensure sufficient safety even when the charging voltage is higher than that of the conventional charging method.

Further, it is preferred that a SOC acquisition unit that acquires information indicating a SOC of the lithium-based secondary battery be additionally provided and that the internal resistance estimation unit estimate the internal resistance value from the information indicating the SOC that has been acquired from the SOC acquisition unit, in addition to the temperature of the lithium-based secondary battery.

The internal resistance value of a lithium-based secondary battery varies depending not only on temperature but also on SOC. Accordingly, with this configuration, the internal resistance estimation unit estimates the internal resistance value of the lithium-based secondary battery by using information indicating the SOC in addition to the temperature of the lithium-based secondary battery, thereby making it possible to increase the estimation accuracy of the internal resistance value.

The internal resistance estimation unit preferably estimates the internal resistance value by using a data table indicating a correspondence relationship between the temperature of the lithium-based secondary battery, information indicating the SOC, and the internal resistance value.

With such a configuration, the internal resistance estimation unit can estimate the internal resistance value of the lithium-based secondary battery by referring to the temperature of the lithium-based secondary battery detected by the temperature detection unit and information indicating the SOC that has been acquired by the SOC acquisition unit using the data table. Therefore, the estimation of the internal resistance value is facilitated.

Further, it is preferred that a deterioration detection unit that detects a deterioration degree indicating a level of deterioration of the lithium-based secondary battery be further provided and that the internal resistance estimation unit estimate the internal resistance value from the deterioration degree detected by the deterioration detection unit, in addition to the temperature of the lithium-based secondary battery and information indicating the SOC.

The internal resistance value of the lithium-based secondary battery varies correspondingly to the level of deterioration of the lithium-based secondary battery. Accordingly, with the above-described configuration, the internal resistance estimation unit estimates the internal resistance value of the lithium-based secondary battery by using the deterioration degree in addition to the temperature of the lithium-based secondary battery and information indicating the SOC, thereby increasing the estimation accuracy of the internal resistance value.

The deterioration detection unit may include an OCV acquisition unit that acquires a terminal voltage detected by the voltage detection unit as an open-circuit terminal voltage when an electric current supplied from the charging current supply unit to the lithium-based secondary battery is zero; a CCV acquisition unit that acquires a terminal voltage detected by the voltage detection unit as a closed-circuit terminal voltage when the quick charging current is supplied from the charging current supply unit to the lithium-based secondary battery; an actual internal resistance calculation unit that calculates an actual internal resistance value of the lithium-based secondary battery as an actual internal resistance value by dividing a difference between the closed-circuit terminal voltage acquired by the CCV acquisition unit and the open-circuit terminal voltage acquired by the OCV acquisition unit by the quick charging current value; and a deterioration degree calculation unit that calculates the deterioration degree so as to indicate a large level of deterioration as the difference between the internal resistance value estimated by the internal resistance estimation unit and the actual internal resistance value calculated by the actual internal resistance calculation unit increases, wherein the charge end voltage calculation unit may correct the charge end voltage so that the charge end voltage decreases as the level of deterioration indicated by the deterioration degree calculated by the deterioration degree calculation unit increases.

With such a configuration, the open-circuit voltage of the lithium-based secondary battery is acquired by the OCV acquisition unit, and the closed circuit voltage of the lithium-based secondary battery is acquired by the CCV acquisition unit. As a result, because the difference between the open-circuit voltage and closed-circuit voltage is caused by a voltage drop at the internal resistance, the actual internal resistance calculation unit can calculate the actual internal resistance value of the lithium-based secondary battery as the actual internal resistance by the difference between the closed-circuit terminal voltage and open-circuit terminal voltage divides by the quick charging current value. The internal resistance value increases as the deterioration of the lithium-based secondary battery advances.

Because the parameter used when the internal resistance estimation unit estimates the internal resistance value does not reflect the deterioration, the internal resistance value estimated by the internal resistance estimation unit becomes the internal resistance value of the lithium-based secondary battery that has not deteriorated. Therefore, the difference between the internal resistance value estimated by the internal resistance estimation unit and the actual internal resistance value calculated by the actual internal resistance calculation unit increases as the deterioration of the lithium-based secondary battery advances. Accordingly, the deterioration degree is calculated by the deterioration degree calculation unit so that the indicated level of deterioration increases as the difference between the internal resistance value estimated by the internal resistance estimation unit and the actual internal resistance value calculated by the actual internal resistance calculation unit increases. Further, the charge end voltage is corrected by the charge end voltage calculation unit so that the charge end voltage decreases as the level of deterioration indicated by the deterioration degree increases.

The deterioration of a lithium-based secondary battery advances easily when the charging voltage increases as the deterioration advances. Therefore, assuming that charging has been conducted to a constant end voltage, regardless of the level of deterioration of a lithium-based secondary battery, the progress in deterioration will increase and deterioration will be accelerated in a battery with advanced deterioration. However, with the above-described configuration, the charge end voltage is corrected so that the charge end voltage decreases as the level of deterioration indicated by the deterioration degree increases. Therefore, the possibility of the deterioration of the lithium-based secondary battery accelerating is reduced.

further, it is preferred that the above-described quick charging method of a lithium-based secondary battery further include a step of detecting a deterioration degree of the lithium-based secondary battery and that the step of estimating the internal resistance value be a step of estimating the internal resistance value from the terminal voltage and the deterioration degree, in addition to the temperature of the lithium-based secondary battery.

With such a configuration, the internal resistance value is found by taking into account not only the temperature of the lithium-based secondary battery, but also the terminal voltage and deterioration degree by reading the internal resistance value that matches the temperature, terminal voltage, and deterioration degree, for example, from a three-dimensional table that has been stored in advance, or finding by interpolation calculations when matching data are not found, or correcting the data on the internal resistance value corresponding to the temperature according to the terminal voltage and deterioration degree.

Therefore, the internal resistance value of the lithium-based secondary battery, that is, the charge end voltage can be found more accurately.

Industrial Applicability

In accordance with the present invention, when a lithium-based secondary battery is charged, the charging current is maintained as a predetermined constant quick charging current and a full charge determination is made at a point of time when the terminal voltage reaches the charge end voltage, instead of the conventional CC-CV charging. The charge end voltage is taken as a voltage obtained by adding a voltage drop amount that is obtained by multiplying an internal resistance value estimated from the temperature of the secondary battery by the quick charging current value to a predetermined charge end voltage. Therefore, a constant high current can be supplied from the beginning of charging to the end and quick charging can be performed up to a full charge, while preventing overcharge, and the present invention can thus be advantageously used for quick charging of the lithium-based secondary battery.

**Claims**

1.   An electronic device comprising:

a lithium-based secondary battery;
a charging current supply unit for quickly charging the lithium-based secondary battery;
a charging control unit that controls a charging current supplied by the charging current supply unit;
a temperature detection unit that detects a temperature of the lithium-based secondary battery;
a voltage detection unit that detects a terminal voltage of the lithium-based secondary battery; and
a setting unit that sets a charge end voltage in the charging control unit, wherein
the charging control unit causes the charging current supply unit to supply a predetermined constant quick charging current to the lithium-based secondary battery and ends the supply of the quick charging current when the terminal voltage detected by the voltage detection unit becomes the charge end voltage that has been set by the setting unit, and
the setting unit comprises:

an internal resistance estimation unit that estimates an internal resistance value of the secondary battery from a temperature of the lithium-based secondary battery detected by the temperature detection unit; and
a charge end voltage calculation unit that estimates a voltage drop amount caused by the internal resistance from the internal resistance value estimated by the internal resistance estimation unit and the quick charging current value and calculates the charge end voltage by adding the voltage drop amount to a preset reference voltage.

2.   The electronic device according to claim 1, wherein the reference voltage is an open-circuit voltage in a fully charged state of the lithium-based secondary battery.

3.   The electronic device according to claim 1 or 2, wherein the lithium-based secondary battery is a nonaqueous electrolyte secondary battery having a heat-resistance layer between a negative electrode and a positive electrode.

4.   The electronic device according to claim 3, wherein the heat-resistant layer is a porous protective film including a resin adhesive and an inorganic oxide filler.

5.   The electronic device according to any one of claims 1 to 4, further comprising a SOC acquisition unit that acquires information indicating a SOC of the lithium-based secondary battery, wherein
the internal resistance estimation unit estimates the internal resistance value from the information indicating the SOC that has been acquired from the SOC acquisition unit, in addition to the temperature of the lithium-based secondary battery.

6.   The electronic device according to claim 5, wherein the internal resistance estimation unit estimates the internal resistance value by using a data table indicating a correspondence relationship between the temperature of the lithium-based secondary battery, information indicating the SOC, and the internal resistance value.

7.   The electronic device according to claim 5 or 6, further comprising: a deterioration detection unit that detects a deterioration degree indicating a level of deterioration of the lithium-based secondary battery, wherein

the internal resistance estimation unit estimates the internal resistance value from the deterioration degree detected by the deterioration detection unit, in addition to the temperature of the lithium-based secondary battery and information indicating the SOC.

8. The electronic device according to claim 5 or 6, wherein
the deterioration detection unit comprises:

an OCV acquisition unit that acquires a terminal voltage detected by the voltage detection unit as an open-circuit terminal voltage when an electric current supplied from the charging current supply unit to the lithium-based secondary battery is zero;
a CCV acquisition unit that acquires a terminal voltage detected by the voltage detection unit as a closed-circuit terminal voltage when the quick charging current is supplied from the charging current supply unit to the lithium-based secondary battery;
an actual internal resistance calculation unit that calculates an actual internal resistance value of the lithium-based secondary battery as an actual internal resistance value by dividing a difference between the closed-circuit terminal voltage acquired by the CCV acquisition unit and the open-circuit terminal voltage acquired by the OCV acquisition unit by the quick charging current value; and
a deterioration degree calculation unit that calculates the deterioration degree so as to indicate a large level of deterioration as the difference between the internal resistance value estimated by the internal resistance estimation unit and the actual internal resistance value calculated by the actual internal resistance calculation unit increases, wherein
the charge end voltage calculation unit corrects the charge end voltage so that the charge end voltage decreases as the level of deterioration indicated by the deterioration degree calculated by the deterioration degree calculation unit increases.

9. The electronic device according to any one of claims 5 to 8, wherein the information indicating the SOC is a terminal voltage of the lithium-based secondary battery.

10. A quick charging method of a lithium-based secondary battery to a predetermined charge end voltage, the method comprising:

a step of continuously supplying a predetermined constant quick charging current;
a step of detecting at least a temperature of the secondary battery;
a step of estimating an internal resistance value of the secondary battery from the detected temperature;
a step of estimating a voltage drop amount caused by the internal resistance from the estimated internal resistance value and the quick charging current value; and
a step of calculating the charge end voltage by adding the voltage drop amount to a preset reference voltage.

11. The quick charging method of a lithium-based secondary battery according to claim 10, wherein the lithium-based secondary battery is a nonaqueous electrolyte secondary battery having a heat-resistance layer between a negative electrode and a positive electrode.

12. The quick charging method of a lithium-based secondary battery according to claim 10 or 11, further comprising a step of detecting a deterioration degree indicating a level of deterioration of the lithium-based secondary battery, wherein
the step of estimating the internal resistance value includes estimating the internal resistance value from the terminal voltage and deterioration degree, in addition to the temperature of the lithium-based secondary battery.

# FIG. 1

**BATTERY PACK 1**

SECONDARY BATTERY — 14

CONTROL IC 18

VOLTAGE DETECTION CIRCUIT — 20

TEMPERATURE SENSOR — 17

A/D CONVERTER — 19

CONTROL UNIT — 21

COMMUNICATION UNIT — 22

CURRENT DETECTION RESISTOR — 16

13 / 12

11

15

T11 (+)

T12 (C)

T13 (−)

**CHARGER 2**

T21 (+)

T22 (C)

T23 (−)

V1

I

VOLTAGE DETECTION CIRCUIT — 34

CONTROL IC 30

COMMUNICATION UNIT — 32

CHARGING CONTROL UNIT — 31

A/D CONVERTER — 35

CHARGING CURRENT SUPPLY CIRCUIT — 33

FIG. 2

INTERNAL
RESISTANCE
VALUE

TEMPERATURE ( °C)

# FIG. 3

START

CHARGING CURRENT IS SUPPLIED — S1

TEMPERATURE T IS RECEIVED — S2

INTERNAL RESISTANCE VALUE R IS READ FROM TABLE — S3

VOLTAGE DROP VD IS CALCULATED — S4

CHARGE END VOLTAGE IS UPDATED AS Vf' — S5

TERMINAL VOLTAGE V1 IS DETECTED — S6

NO — $V1 \geqq Vf'$ — S7

YES

CHARGING CURRENT SUPPLY IS ENDED — S8

END

FIG. 4A

FIG. 4B

## FIG. 5

```
              START
                │
                ▼
┌──────────────────────────────┐  S1
│  CHARGING CURRENT IS SUPPLIED │
└──────────────────────────────┘
                │
                ▼
┌──────────────────────────────┐  S2'
│  TEMPERATURE T, SOC, ACTUAL   │
│  CAPACITY W ARE RECEIVED      │
└──────────────────────────────┘
                │
                ▼
┌──────────────────────────────┐  S3'
│  INTERNAL RESISTANCE VALUE R IS│
│  READ OUT FROM TABLE          │
└──────────────────────────────┘
                │
                ▼
┌──────────────────────────────┐  S4
│  VOLTAGE DROP VD IS CALCULATED│
└──────────────────────────────┘
                │
                ▼
┌──────────────────────────────┐  S5
│  CHARGE END VOLTAGE IS        │
│  UPDATED AS Vf'               │
└──────────────────────────────┘
                │
                ▼
┌──────────────────────────────┐  S6
│  TERMINAL VOLTAGE V1 IS       │
│  DETECTED                     │
└──────────────────────────────┘
                │
                ▼
         NO   ╱────────╲  S7
        ◄─────  V1 ≧ Vf'  
              ╲────────╱
                │ YES
                ▼
┌──────────────────────────────┐  S8
│  CHARGING CURRENT SUPPLY IS   │
│  ENDED                        │
└──────────────────────────────┘
                │
                ▼
              END
```

FIG. 6

FIG. 7A

FIG. 7B

FIG. 8

# FIG. 9

START

INITIAL CHARGE END VOLTAGE Vf IS SET — S11

OPEN-CIRCUIT VOLTAGE OF SECONDARY BATTERY 14 IS DETECTED AS VOLTAGE V1' — S12

EXECUTION OF CONSTANT-CURRENT CHARGING IS STARTED — S13

CHARGING CURRENT I IS DETECTED — S14

TERMINAL VOLTAGE V1 IS DETECTED — S15

INTERNAL RESISTANCE R' = (V1 − V1')/I — S16

VOLTAGE DROP AMOUNT VD = R' × I — S17

CHARGE END VOLTAGE Vf' = Vf + VD — S18

V1 ≧ Vf' ? — S19

CHARGING CURRENT SUPPLY IS ENDED — S20

END

WAIT FOR 1 sec  t ← t+1 — S21

t ≧ 300 — S22

t ← 0 — S23

CHARGING CURRENT SUPPLY IS ENDED — S24

FIG. 10

CHARGER 2a

LOAD DEVICE — 4

BATTERY PACK 1b

33
CHARGING CURRENT SUPPLY CIRCUIT

CONTROL IC 30

31a
CHARGING CONTROL UNIT

32
COMMUNICATION UNIT

T21  T11

T22  T12

T23  T13

11  12  13  I

CONTROL IC 18

CONTROL UNIT — 21b

22  210
COMMUNICATION UNIT

CHARGING CONTROL UNIT

SOC ACQUISITION UNIT

213
DETERIORATION DETECTION UNIT

214
INTERNAL RESISTANCE ESTIMATION UNIT

211b

212b
CHARGE END VOLTAGE CALCULATION UNIT

19
A/D CONVERTER

20
VOLTAGE DETECTION CIRCUIT

17
TEMPERATURE SENSOR

14
SECONDARY BATTERY

V1

15
16
CURRENT DETECTION RESISTOR

EP 2 131 440 A1

# FIG. 11

START

INITIAL CHARGE END VOLTAGE Vf IS SET ⌐S11

OPEN-CIRCUIT VOLTAGE OF SECONDARY BATTERY 14 IS DETECTED AS VOLTAGE V1' ⌐S12

EXECUTION OF CONSTANT-CURRENT CHARGING IS STARTED ⌐S13

ACTUAL INTERNAL RESISTANCE R' IS DETECTED ⌐S30

DETERIORATION COEFFICIENT P IS CALCULATED ⌐S40

VOLTAGE DROP AMOUNT VD = R' × I ⌐S17

CHARGE END VOLTAGE Vf' = P × Vf + VD ⌐S50

V1 ≧ Vf' ? ⌐S19

CHARGING CURRENT SUPPLY IS ENDED ⌐S20

END

CHARGING CURRENT SUPPLY IS ENDED ⌐S24

t ← 0 ⌐S23

t ≧ 300 ⌐S22

WAIT FOR 1 sec t ← t+1 ⌐S21

YES

NO

NO

YES

# FIG. 12

DETECTION OF ACTUAL
INTERNAL RESISTANCE R'

CHARGING CURRENT I IS DETECTED — S31

TERMINAL VOLTAGE V1 IS DETECTED — S32

ACTUAL INTERNAL RESISTANCE R' = (V1 − V1')/I — S33

RETURN

# FIG. 13

```
            ┌─────────────────────────────┐
            │   CALCULATION OF            │
            │  DETERIORATION COEFFICIENT P │
            └─────────────────────────────┘
                        │
                        ▼                        S41
            ┌─────────────────────────────┐
            │  TEMPERATURE T OF SECONDARY  │
            │    BATTERY 14 IS DETECTED    │
            └─────────────────────────────┘
                        │
                        ▼                        S42
            ┌─────────────────────────────┐
            │     SOC OF SECONDARY         │
            │  BATTERY 14 IS CALCULATED    │
            └─────────────────────────────┘
                        │
                        ▼                        S43
         ┌───────────────────────────────────┐
         │ INTERNAL RESISTANCE VALUE R IS ESTIMATED │
         │  ON THE BASIS OF TEMPERATURE T AND │
         │   SOC BY REFERRING TO DATA TABLE   │
         └───────────────────────────────────┘
                        │
                        ▼                        S44
         ┌───────────────────────────────────┐
         │  BATTERY DETERIORATION COEFFICIENT P │
         │ IS CALCULATED FROM INTERNAL RESISTANCE │
         │ VALUE R AND ACTUAL INTERNAL RESISTANCE │
         │            VALUE R'                │
         └───────────────────────────────────┘
                        │
                        ▼
               ┌──────────────┐
               │    RETURN     │
               └──────────────┘
```

## FIG. 14

Block diagram showing:
- 1c — containing PROTECTION CIRCUIT (T11), SECONDARY BATTERY (14), TEMPERATURE SENSOR (17), terminals T11, T12, T13
- 2c — containing terminals T21, T22, T23, VOLTAGE DETECTION, CURRENT DETECTION UNIT, LOAD DEVICE (4), CHARGING CURRENT SUPPLY CIRCUIT (33), CHARGING CONTROL UNIT (31a), A/D CONVERTER (35), COMMUNICATION UNIT (32), 30c, SOC ACQUISITION UNIT (213), DETERIORATION DETECTION UNIT (214), INTERNAL RESISTANCE ESTIMATION UNIT (211 (211b)), CHARGE END VOLTAGE CALCULATION UNIT (212 (212b))

## INTERNATIONAL SEARCH REPORT

| | International application No. |
|---|---|
| | PCT/JP2008/000461 |

A.  CLASSIFICATION OF SUBJECT MATTER
*H01M10/44*(2006.01)i, *H01M4/02*(2006.01)i, *H01M10/48*(2006.01)i, *H02J7/10*(2006.01)i

According to International Patent Classification (IPC) or to both national classification and IPC

B.  FIELDS SEARCHED

Minimum documentation searched (classification system followed by classification symbols)
H01M10/42-10/48, H01M4/02, H02J7/00-7/12, H02J7/34-7/36

Documentation searched other than minimum documentation to the extent that such documents are included in the fields searched
    Jitsuyo Shinan Koho      1922-1996   Jitsuyo Shinan Toroku Koho   1996-2008
    Kokai Jitsuyo Shinan Koho   1971-2008   Toroku Jitsuyo Shinan Koho   1994-2008

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| Y<br>A | JP 2005-322592 A  (Sony Corp.),<br>17 November, 2005 (17.11.05),<br>Full text<br>(Family: none) | 1-7,9-12<br>8 |
| Y | JP 2007-26696 A  (Nissan Motor Co., Ltd.),<br>01 February, 2007 (01.02.07),<br>Par. No. [0026]; Fig. 7<br>& US 2007/0013347 A1 | 1-7,9-12 |
| Y | JP 2006-338944 A  (Nissan Motor Co., Ltd.),<br>14 December, 2006 (14.12.06),<br>Par. Nos. [0011] to [0012]; Figs. 3, 4<br>(Family: none) | 1-7,9-12 |

☒ Further documents are listed in the continuation of Box C.  ☐ See patent family annex.

*    Special categories of cited documents:
"A"  document defining the general state of the art which is not considered   to be of particular relevance
"E"  earlier application or patent but published on or after the international filing date
"L"  document which may throw doubts on priority claim(s) or which is cited to establish the publication date of another citation or other special reason (as specified)
"O"  document referring to an oral disclosure, use, exhibition or other means
"P"  document published prior to the international filing date but later than the priority date claimed

"T"  later document published after the international filing date or priority date and not in conflict with the application but cited to understand the principle or theory underlying the invention
"X"  document of particular relevance; the claimed invention cannot be considered novel or cannot be considered to involve an inventive step when the document is taken alone
"Y"  document of particular relevance; the claimed invention cannot be considered to involve an inventive step when the document is combined with one or more other such documents, such combination being obvious to a person skilled in the art
"&"  document member of the same patent family

| Date of the actual completion of the international search<br>27 March, 2008 (27.03.08) | Date of mailing of the international search report<br>08 April, 2008 (08.04.08) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2008/000461

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2003-319503 A (Toyota Motor Corp.), 07 November, 2003 (07.11.03), Par. No. [0040]; Fig. 4 (Family: none) | 1-7,9-12 |
| Y | JP 2003-22844 A (Japan Storage Battery Co., Ltd.), 24 January, 2003 (24.01.03), Par. No. [0004] (Family: none) | 7,9,12 |
| Y | JP 2002-156427 A (GS Melcotec Co., Ltd.), 31 May, 2002 (31.05.02), Figs. 2, 4, 5 (Family: none) | 7,9,12 |
| Y | JP 2001-174532 A (NTT Docomo Inc.), 29 June, 2001 (29.06.01), Par. No. [0021]; Fig. 6 (Family: none) | 7,9,12 |
| Y | JP 3371301 B2 (Sony Corp.), 27 January, 2003 (27.01.03), Claim 3 (Family: none) | 3-9,11,12 |
| A | JP 2002-142379 A (Sanyo Electric Co., Ltd.), 17 May, 2002 (17.05.02), (Family: none) | 1-12 |
| A | JP 10-214643 A (Hitachi, Ltd.), 11 August, 1998 (11.08.98), & US 5903136 A | 1-12 |
| A | JP 10-145979 A (Nissan Motor Co., Ltd.), 29 May, 1998 (29.05.98), (Family: none) | 1-12 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H11285162 B
- JP 2005185060 A
- JP 3371301 B
- JP 2005261020 A
- JP H10214643 B